Europäisches Patentamt

European Patent Office

Office européen des brevets

(19)

(11) Veröffentlichungsnummer: **0 172 470**
**B1**

(12) **EUROPÄISCHE PATENTSCHRIFT**

(45) Veröffentlichungstag der Patentschrift: **04.04.90**

(51) Int. Cl.⁵: **G 01 R 31/28**

(21) Anmeldenummer: **85109684.2**

(22) Anmeldetag: **01.08.85**

(54) **Verfahren und Vorrichtung zur Detektion und Abbildung von Messpunkten, die einen bestimmten Signalverlauf aufweisen.**

(30) Priorität: **06.08.84 DE 3428965**

(43) Veröffentlichungstag der Anmeldung:
**26.02.86 Patentblatt 86/09**

(45) Bekanntmachung des Hinweises auf die
Patenterteilung:
**04.04.90 Patentblatt 90/14**

(84) Benannte Vertragsstaaten:
**AT BE DE FR GB NL**

(56) Entgegenhaltungen:
**US-A-4 220 853**

**JOURNAL OF VACUUM SCIENCE &
TECHNOLOGY, vol 19, no. 4,
november/december 1981, PFEIFFER et
al.:"Contactless electrical testing of large area
specimens using electron beams", pages 1014-
1018**

(73) Patentinhaber: **Siemens Aktiengesellschaft
Wittelsbacherplatz 2
D-8000 München 2 (DE)**

(72) Erfinder: **Brust, Hans-Detlef
Martin-Luther-Strasse 2
D-6602 Dudweiler (DE)**

Courier Press, Leamington Spa, England.

**Beschreibung**

Die Erfindung betrifft ein Verfahren und eine Vorrichtung zur Detektion und/oder Abbildung eines oder mehrerer Meßpunkte auf einer Probe, die ein bestimmtes Signal führen.

Bei fehlerhaftem Verhalten von integrierten Schaltungen besteht der Wunsch, zum Auffinden eines Fehlers das Verhalten der integrierten Schaltung mit dem Soll-Verhalten, so wie es sich aus der Simulation ergibt, zu vergleichen. Hierzu muß u.a. überprüft werden, ob bestimmte Signalverläufe an einem oder mehreren Meßpunkten innerhalb der integrierten Schaltung vorhanden sind.

Aus dem Stand der Technik sind bisher fünf Verfahren bekannt, mit deren Hilfe eine solche Überprüfung vorgenommen werden kann. Aus "Scanning Electron Microscopy" 1975 (part I), Proc. of the Eight Annual Scanning Electron Microscope Symposium, Chicago, IIT Research Institute, Seiten 465—471, ist das Verfahren des sogenannten "voltage coding" bekannt. Das "voltage coding"-Verfahren bildet die dynamische Potentialverteilung einer integrierten Schaltung auf einem Fernsehmonitor ab. Das "voltage coding"-Verfahren ermöglicht eine zeitliche Zuordnung der Schaltzustände in den verschiedenen Bauelementen und ist daher besonders zur schnellen Funktionsprüfung von integrierten Schaltungen geeignet. Der schwerwiegenste Nachteil dieses Verfahrens ist jedoch seine geringe obere Grenzfrequenz.

Aus der US-Patentschrift 4 223 220 ist das sogenannte "Logic State Mapping"-Verfahren bekannt. Bei diesem "Logic State Mapping"-Verfahren wird die dynamische Potentialverteilung mit Hilfe eines Stroboskopeffekts abgebildet. Dieses "Logic State Mapping"-Verfahren liefert, vergleichen mit dem "voltage coding"-Verfahren bei gleicher Potentialauflösung, eine um Größenordnungen höhere Zeitauflösung. Das "Logic State Mapping"-Verfahren vereinfacht außerdem die Aufzeichnung, da die Abbildungen der dynamischen Potentialverteilung direkt vom Fotobildschirm eines RasterElektronenmikroskops abfotografiert werden könen. Bei dem "voltage coding"-Verfahren ist dagegen eine Aufzeichnung nur mit einem Bandspeicher oder mit Fotos von einem Fernsehmonitor möglich.

Nach einem dritten bekannten Verfahren (beschrieben in: H.P. Feuerbaum, Electron Beam Testing: Methods and Applications, Scanning, Vol. 5, 1983, Seiten 14—24), das als "Waveform"-Messung bezeichnet wird, ist es möglich, den zeitlichen Signalverlauf an einem Meßpunkt zu messen. Durch Einsatz einer Sampling-Methode ist dieses Verfahren in der Lage, auch noch sehr schnelle Signalverläufte mit hoher Zeitauflösung aufzuzeichnen. Allerdings ist die Messung sehr langwierig (i.a. mehrere Minuten) und relativ kompliziert.

Mit Hilfe zweier weiterer Verfahren ist es möglich, die Meßpunkte aufzufinden, die periodische Signale bestimmter Frequenzen führen. Beim ersten dieser Verfahren (Verfahren von J. P. Collin in Proc. of Jornees d'Electronique 1983, "Testing Complex Integrated Circuits: A Challenge", herausgegeben vom Swiss Federal Institute of Technology, Lausanne, Schweiz, seiten 283—298, Titel: "Une Alternative Economique au Contraste Potentiel Stroboscopique: Le Traitement du Signal d'Electrons Secondaires d'un Microscope a Balayage") wird das Auffinden bestimmter Frequenzen an einem Meßpunkt unter Verwendung eines "lock-in"-Verstärkers durchgeführt. Dabei wird aus einem an einem Meßpunkt am Innern einer integrierten Schaltung gewonnenen Potentialkontrastsignal mit Hilfe des "lock-in"-Verstärkers ein Signal mit der gesuchten Frequenz ausgefiltert und dann die Intensität dieses Signals als Helligkeitsschwankung abgebildet. Dieses Verfahren ist indes sehr langsam und weist nur eine geringe obere Grenzfrequenz auf.

Kombiniert man das zuletzt genannte Verfahren mit einer stroboskopischen Abbildungsmethode, so kann man die Bandbreitenbegrenzung überwinden. Dieses modifizierte Verfahren (beschrieben in: H. D. Brust, F. Fox, E. Wolfgang, Frequency Mapping and Frequency Tracing: Two Novel Electron Beam Testing Methods, Vortrag auf der Microcircuit Engineering Konferenz in Berlin, September 1984 geplant) wird als "Frequency Mapping"-Verfahren bezeichnet. Das "Frequency-Mapping"-Verfahren erlaubt ebenso wie das Verfahren von J. P. Collin nur zu überprüfen, ob an einem Meßpunkt ein Signal einer bestimmten Frequenz anliegt. Es macht keine Aussage darüber, wie der tatsächliche Signalverlauf aussieht.

Die genannten Verfahren, wie sie aus dem Stand der Technik bekannt sind, sind teilweise nur schwer durchführbar, erlauben teilweise nur eine Überprüfung einiger weniger oder gar nur einer einzelnen Leiterbahn oder sind in ihrem Arbeitsfrequenzbereich stark eingeschränkt, wodurch eine Überprüfung der integrierten Schaltung unter normalen Betriebsbedingungen häufig nicht möglich ist. Überdies sind die aus dem Stand der Technik bekannten Verfahren teilweise sehr langsam und setzen voraus, daß man den Vergleich des gemessenen mit dem erwarteten Signalverlauf manuell vornimmt bzw. daß man bei Signalen gleicher Grundfrequenz selbst entscheidet, ob der erwartete Signalverlauf tatsächlich vorliegt.

Der vorliegenden Erfindung liegt die Aufgabe zugrunde, ein Verfahren und eine Vorrichtung der eingangs genannten Art anzugeben, mit deren Hilfe es schnell möglich ist zu überprüfen, ob an einem Meßpunkt im Innern einer integrierten Schaltung ein bestimmter erwarteter Signalverlauf anliegt, bzw. bei fehlerhaften elektronischen Bauelementen zu ermitteln, ob eventuell ein bestimmter Signalverlauf nicht vorhanden ist.

Diese Aufgaben werden erfindungsgemäß durch ein Verfahren moule Anspruch 1 und Vorrichtungen moule den Ansprüchen 21 und 23 gelost.

Gegenüber den aus dem Stand der Technik bekannten Verfahren ist ein Verfahren nach der Erfindung wesentlich schneller und gestattet eine automatische Suche nach einem bestimmten vorgegebenen oder gemessenen Signalverlauf. Außerdem ist das Verfahren bis zu sehr hohen Arbeitsfrequenzen einsetzbar. Ein Verfahren und eine Vorrichtung nach der Erfindung ermöglicht damit eine schnelle und großflächige Durchführung einer Funktionsprüfung bzw. Fehlersuche im Innern einer integrierten Schaltung auch unter normalen Betriebsbedingungen.

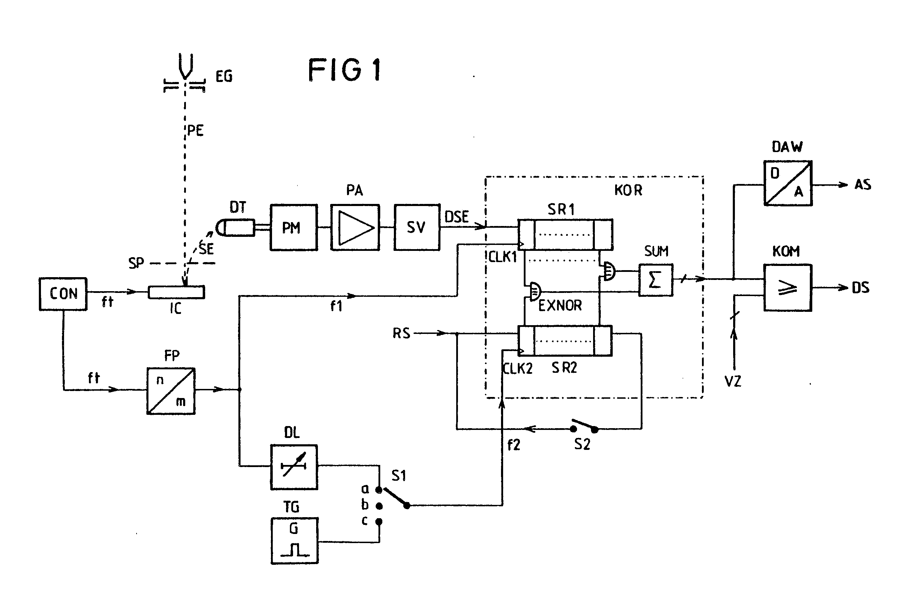

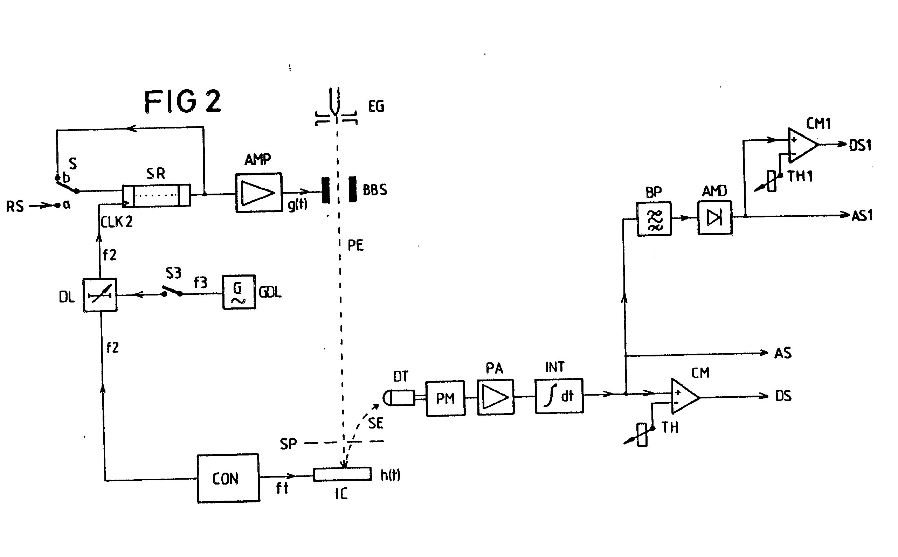

Ausführungsbespiele der Erfindung sind in der Zeichnung dargestellt und werden im folgenden näher beschrieben. In den Fig. 1 und 2 sind gleiche Merkmale bzw. Gegenstände mit gleichen Bezugszeichen versehen. Obwohl sich die folgenden Ausführungsbeispiele auf ein Elektronenmikroskop beziehen, ist die Erfindung so zu verstehen, daß anstelle von Elektronen auch Ionen oder andere Korpuskel verwendet werden können, und zwar sowohl als Primärkorpuskeln als auch als Sekundärkorpuskeln. Außerdem werden in den folgenden Ausführungsbeispielen stets digitale Signalverläufe untersucht. Selbstverständlich ist ein Verfahren und eine Vorrichtung nach der Erfindung auch in der Lage, einen Meßpunkt auf das Vorliegen eines bestimmten analogen Signalverlaufs zu überprüfen, sofern man einen geeigneten Korrelator verwendet.

Fig. 1 zweigt eine Vorrichtung nach der Erfindung zur Detektion und/oder Abbildung eines Meßpunktes oder einer Leiterbahn, die einen bestimmten Signalverlauf aufweist. Als Grundgerät für eine solche Vorrichtung nach Fig. 1, aber ebenfalls auch nach Fig. 2, kann ein Raster-Elektronenmikroskop verwendet werden, wie es aus den US-Patentschriften mit den Nummern 4 220 853 bzw. 4 220 854 bzw. 4 277 679 für eine quantitative Potentialmessung und aus der US-Patentschrift 4 223 220 für eine qualitative Potentialmessung bekannt ist. Auch bei den Vorrichtungen nach den Fig. 1 und 2—ebenso wie einem Verfahren nach der Erfindung—kann selbstverständlich der integrierte Schaltkreis IC durch eine beliebige Probe ersetzt werden, die wenigstens einen Meßpunkt besitzt, der möglicherweise einen bestimmten Signalverlauf aufweist.

Aus einer Elektronenquelle EG treten Primärelektronen PE aus, die auf einen Meßpunkt oder auf eine Leiterbahn innerhalb eines integrierten Schaltkreises IC auftreffen und dort Sekundärelektronen SE auslösen. Diese Sekundärelektronen SE werden in einem Detektor DT nachgewiesen. Durch den an der Oberfläche der integrierten Schaltung entstehenden Potentialkontrast hängt die Zahl der Sekundärelektronen SE, die den Detektor DT erreichen, von der Spannung der integrierten Schaltung IC am Meßort ab. In Abhängigkeit vom Sekundärelektronenstrom, der auf den Detektor DT trifft, wird in diesem Detektor DT ein Sekundärelektronensignal erzeugt, das zu einem Photomultiplier PM geführt und dort verstärkt wird. Das im Photomultiplier verstärkte Sekundärelektronensignal wird weiter zu einem Vorverstärker PA geleitet. Das im Vorverstärker PA weiter verstärkte Sekundärelektronensignal gelangt schließlich zu einer Schaltung SV, in der es geeigneten Signalverarbeitungsmethoden zur Verbesserung des Signal-Rausch-Verhältnisses (z.B. einer Optimalfilterung) unterzogen und in ein reines Digitalsignal DSE umgewandelt wird. Dieses digitale Sekundärelektronensignal, das die Spannung der integrierten Schaltung am Meßort wiedergibt, wird sodann dem digitalen Korrelator KOR zugeführt.

Dar dargestellte innere Aufbau des Korrelators orientiert sich weitgehend am Aufbau des Korrelators TDC 1023J von TRW. Andere Ausführungen des Korrelators sind selbstverständlich ebenfalls möglich. Zunächst wird das erwartete Referenzsignal RS, von dem überprüft werden soll, ob es am Meßpunkt auftritt, in das Schieberegister SR2 eingelesen. Das hierzu erforderliche Taktsignal liefert der Taktgenerator TG (Schalter Sf in Schaltstellung c). Nach dem Einlesen des Referenzsignals RS wird der Schalter S1 in Schaltstellung b gebracht und dadurch das Schieberegister SR2 mit dem Referenzsignal RS vom Ausgang des Taktgenerators TG getrennt. Der Inhalt des Schieberesters bleibt während der Durchführung der Überprüfung unverändert.

Während der Messung wird das Sekundärelektronensignal DSE fortwährend mit der Frequenz f1 abgetastet und in das Schieberegister SR1 eingelesen. Das Taktsignal CLK1 der Frequenz f1 sollte dabei synchron zu der Arbeitsfrequenz der integrierten Schaltung sein. Es kann beispielsweise durch Frequenzteilung oder -vervielfachung mit Hilfe eines Frequenzteilers oder -vervielfachers FP aus der Taktfrequenz ft der integrierten Schaltung IC gewonnen werden. Da die integrierte Schaltung IC von der Ansteuerung CON mit einem Taktsignal der Frequenz ft angetrieben wird, ist diese Frequenz leicht zugänglich und kann von der Ansteuerung CON dem Frequenzteiler bzw. -vervielfacher FP geliefert werden. Prinzipiell ist aber jedes zu dem am Meßpunkt anliegende Signal synchrone Signal als Taktsignal CLK1 für das Schieberegister SR1 geeignet. Die Frequenz f1 muß dabei so gewählt werden, daß in dem Schieberegister SR1 ein genügend großer Zeitausschnitt des Signalverlaufs am Meßpunkt gespeichert werden kann (mindestens so groß wie das Zeitintervall, das der erwartete Signalverlauf einnimmt). Mit Hilfe der Äquivalenzgatter EXNOR werden die Speicherinhalte der Schieberegister SR1 und SR2 auf Übereinstimmung geprüft. Die Anzahl der übereinstimmenden Speicherstellen der Schieberegister SR1 und SR2 wird mit Hilfe der Summationsschaltung SUM festgestellt und als Binärzahl ausgegeben. Diese Binärzahl kann daraufhin mit Hilfe eines Digital-Analog-Wandlers DAW in ein Analogsignal AS umgewandelt oder aber mit Hilfe eines digitalen Komparators KOM mit einer Vergleichszahl VZ verglichen werden. Ist die Anzahl der Übereinstimmungen größer als VZ, so geht der Digitalausgang DS des Komparators KOM auf logisch 1, anderenfalls ist er 0.

Erscheint in dem abgetasteten Sekundärelektronensignal DSE also irgendwann eine Bitfolge, die dem in das Vergleichsschieberegister SR2 eingelesenen Referenzsignal RS entspricht, so zeigt die Summationsschaltung maximale Übereinstimmung an, und der Ausgang DS geht auf logisch 1 und der Analogausgang AS nimmt seinen maximalen Spannungswert an. Da das gemessene Sekundärelektronensignal DSE durch Rauschen oder andere Störungen u.U. vom Signal am Meßort leicht abweichen kann, wird man häufig schon davon ausgehen, daß das gesuchte Referenzsignal RS vorliegt, wenn zwar keine vollständige, aber doch hochgradige Übereinstimmung zwischen dem Referenzsignal RS und dem gemessenen Signal DSE herrscht. Die entsprechende Schwelle, also die Zahl der Übereinstimmungen, die erforderlich ist, um das gemessene Signal als die gesuchte Bitfolge zu interpretieren, kann mit Hilfe der Vergleichszahl VZ eingestellt werden.

In der zuvor beschriebenen Vorrichtung nach der Erfindung wird also überprüft, ob der vorgegebene Signalverlauf RS überhaupt am Meßort auftritt. Zusätzlich kann, sofern am Meßort ein periodisches Signal erwartet wird, in einer weiteren Ausgestaltung der Erfindung noch überprüft werden, ob das erwartete Signal RS am Meßort zu einer bestimmten festen Phase auftritt. Auch diese Vorrichtung ist in Fig. 1 dargestellt. Dazu wird das Schieberegister SR2 mit dem Referenzsignalverlauf RS durch Schließen des Schalters S2 als Ringschieberegister geschaltet und ebenfalls mit dem Taktsignal CLK1 getaktet (Schalter S1 in Schaltstellung a). Die Phase zu der überprüft werden soll, ob das erwartete Referenzsignal am Meßort anliegt, kann dabei durch Verändern der Verzögerungszeit des Verzögerungsgliedes DL verschoben werden. Ansonsten arbeitet die Meßvorrichtung wie die zuvor beschriebene.

Zur großflächigen Überprüfung einer integrierten Schaltung IC wird der Elektronenstrahl über die Probenoberfläche gerastert. Die Abrasterung muß dabei so langsam erfolgen, daß an jedem Meßort der gesamte interessierende Zeitraum, in dem das erwartete Signal auftreten kann—bei periodischen Signalen ist dies z.B. eine Periode-, auch tatsächlich überprüft wird, oder aber die Überprüfung muß periodisch vorgenommen werden. Die Ausgangssignale AS und DS zeigen dann an, ob an dem Ort, auf den der Elektronenstrahl auftrifft, der gesuchte Signalverlauf überhaupt bzw. phasenrichtig auftritt. Zeichnet man die Signale AS oder DS in Abhängigkeit vom Meßort mit Hilfe eines geeigneten Aufzeichnungsverfahrens (z.B. durch Einlesen in einen Rechner oder Abspeichern auf einem Magnetband) auf, so erhält man ein Bild der Oberflächenstrukturen der Probe IC, die den gesuchten Signalverlauf phasenrichtig oder überhaupt aufweisen. Eine einfache Aufzeichnungsmöglichkeit besteht darin, das Signal DS zur Helligkeitsmodulation der Bildröhre des Raster-Elektronenmikroskops heranzuziehen. In diesem Fall werden alle Leiterbahnen, die das gesuchte Signal führen, hell dargestellt. Zur besseren Orientierung in der zweidimensionalen Abbildung einer Probe kann es von Vorteil sein, das Sekundärelektronen-Topographiesignal oder ein anderes Topographiesignal in abgeschwächter Form zum Ausgangssignal AS oder DS hinzuzuaddieren. Wie ein solches Topographiesignal gewonnen werden kann, ist in Lehrbüchern für Raster-Elektronenmikroskopie zu finden und daher dem Fachmann bekannt.

Schaltet man in einer Anordnung nach Fig. 1 mehrere Korrelatoren parallel, so kann man gleichzeitig das Vorliegen mehrerer unterschiedlicher Signalverläufe an einem Meßpunkt prüfen. Zur großflächigen Prüfung einer integrierten Schaltung IC müssen in diesem Fall die verschiedenen Ausgangssignale parallel in Abhängigkeit vom Meßort aufgezeichnet werden. Hierzu kann man etwa an Stelle der Bildröhre des Raster-Elektronenmikroskops eine Farbbildröhre verwenden und jedem Korrelatorausgang und damit jedem Referenzsignalverlauf eine Farbe zuordnen.

Die zuvor beschriebene Meßvorrichtung ist zur Untersuchung analoger Signale nur schlecht geeignet, da aufgrund des Potentialkontrasts der Zusammenhang zwischen Spannung am Meßort und Sekundärelektronenstrom nichtlinear ist. Für die Untersuchung analoger Signalverläufe empfiehlt es sich an Stelle des Potentialkontrasts die lineare Energieverschiebung der Sekundärelektronen SE zu messen. Diese Energieverschiebung kann mit Hilfe eines Spektrometers SP, wie es etwa aus der US—PS—4 292 519 bekannt ist, in einen entsprechenden Sekundärelektronenstrom umgewandelt werden. Der so gewonnene Sekundärelektronenstrom kann dann wie zuvor beschrieben weiterverarbeitet werden. Überdies verringert ein Spektrometer Störeinflüsse durch Fernfelder auf der Probe und ist dadurch auch für die Untersuchung digitaler Signalverläufe von Vorteil.

Die Grenzfrequenz der in Fig. 1 dargestellten Meßvorrichtung wird im wesentlichen durch den Detektor DT bestimmt und liegt i.a. bei 1—5 Mhz. Um das Verfahren nach der Erfindung auch bei höheren Frequenzen einsetzen zu können, muß man die Korrelation vor dem Detektor DT vornehmen. Eine dazu geeignete Ausgestaltung der Erfindung zeigt Fig. 2. Hier wird die Korrelation durch den Elektronenstrahl selbst durchgeführt. Dazu wird der Primärelektronenstrahl PE mit Hilfe eines Strahlaustastsystems BBS, wie es beispielsweise aus US-Patentschrift 4 169 229 bekannt ist, intensitätsmoduliert. Die mit der zu einer Arbeitsfrequenz der integrierten Schaltung IC synchronen Frequenz f2 abgetastete gesuchte Bitfolge RS wird vor Beginn der Messung in das Schieberegister SR eingelesen (Schalter S in Schaltstellung a). Während der Messung wird der Inhalt des Schieberegisters SR durch das Taktsignal CLK2 mit der Frequenz f2 zyklisch verschoben. Das Ausgangssignal des Schieberegisters steuert dann von einem Verstärker AMP verstärkt das Strahlaustastsystem BBS. Bezeichnet man den Signalverlauf am Strahlaustastsystem mit g(t), so schwankt die Intensität des Primärelektronenstrahles PE proportional zu g(t). Am Meßort auf der integrierten Schaltung IC leigt das Signal h(t) an. Der Sekundärelektronenstrom ist daher proportional zu g(t)*h(t). Der Sekundärelektronenstrom wird vom Detektor DT registriert und im Photomultiplier PM und im Vorverstärker PA verstärkt. Das Ausgangssignal des Vorverstärkers PA wird sodann vom Integrator INT integriert. Das Ausgangssignal des Integrators ist also proportional zu ∫g(t)*h(t)*dt. Da g(t) und h(t) beides digitale Signale sind, können sie nur den Wert 0 oder 1 annehmen. Stimmen beide Signale im Integrationszeitraum (in den L-bzw. H-Werten) überein (in der Bitfolge und der Phase des Auftretens), so wird der Wert des Integrals maximal. Das Ausgangssignal des Integrators INT ist also ein Maß für die Übereinstimmung des Signals am Meßort und des Referenzsignals RS. Die Integrationszeit des Integrators muß daher mindestens so groß wie die Dauer des inte- ressierenden Signalverlaufs sein.

Soll eine großflächige Überprüfung der integrierten Schaltung IC vorgenommen werden, so muß die Abrasterung der Probenoberfläche durch den Elektronenstrahl so langsam erfolgen, daß der Strahl an jedem Meßpunkt wenigstens die Integrationszeit verweilt, oder aber die Überprüfung muß periodisch vorgenommen werden. Das analoge Ausgangssignal AS des Integrators INT kann dann aufgezeichnet und beispeilsweise auf einer Bildröhre, wie sie Bestandteil des für die Vorrichtung nach Fig. 2 verwendeten Raster-Elektronenmikroskops ist, dargestellt werden. Zur Kontrastverbesserung kann das Signal AS noch an den +Eingang eines Komparators CM angelegt werden, dessen −Eingang mit einer variablen Ansprechschwelle TH verbunden ist. Der Komparator CM wandelt das Analogsignal AS in ein digitales Signal DS um, das ebenfalls die Helligkeit einer Bildröhre steuern kann. Auch bei dieser Meßanordnung kann aus den schon erwähnten Gründen die Verwendung eines Spektrometers von Vorteil sein. Unter Umständen kann auf einen Integrator als eigenständiges Bauelement ganz verzichtet werden, da für hohe Frequenzen der Detektor DT und für niedrige Frequenzen bei geeigneter Wahl der Rastergeschwindigkeit die Bildröhre des Raster-Elektronenmikroskopes selbst integrierend wirken.

Die Vorrichtung nach Fig. 2 überprüft in der bisher beschriebenen Anordnung, ob an dem untersuchten Meßpunkt ein bestimmter Signalverlauf phasenrichtig auftritt. Durch Verändern der Verzögerungszeit des Verzögerungsgliedes DL, kann die Phase zu der dies überprüft wird, verschoben werden. Die obere Grenzfrequenz dieser Meßvorrichtung wird durch das verwendete Strahlaustastsystem BBS bestimmt. Zur Zeit sind Strahlaustastsysteme verfügbar, die bis in den GHz-Bereich arbeiten. Daher kann eine solche Vorrichtung und ein Verfahren nach der Erfindung auch zur überprüfung von integrierten Schaltungen unter realen Betriebsbedingungen eingesetzt werden.

Mit der in Fig. 2 dargestellten Anordnung ist es aber auch möglich unabhängig von der Phase zu überprüfen, ob an einem Meßpunkt ein bestimmter Signalverlauf vorliegt. Dazu wird das Verzögerungsglied DL, das nun elektrisch steuerbar sein muß, von einem Generator GDL mit der Frequenz f3 angesteuert. Als Verzögerungsglied DL kann man etwa eine Verzögerungsleitung mit mehreren Anzapfungen, eine sogenannte "tapped delay line", deren Ausgänge über einen von einem Analog-Digital-Wandler angesteuerten Multiplexer zum Schieberegister SR geführt werden, verwenden. Ist 2*Dt die Gesamtverzögerung des Verzögerungsgliedes VZ, so wird das Taktsignal CLK2 mit Dt*(1+cos(2πf3)) verzögert. Damit ist der Primärelektronenstrom proportional zu g(t+Dt*(1+cos(2πf3))).

Ist die Integrationszeit des Integrators INT wesentlich kleiner als die Periodendauer 1/2πf3, mit der der Primärelektronenstrom moduliert wird, so schwankt das Ausgangssignal des Integrators INT periodisch mit der Frequenz f3, sofern die Referenzbitfolge und das am Meßort anliegende Signal übereinstimmen. Gibt es nur wenige Übereinstimmungen, so liefert der Integratorausgang einen nahezu zeitunabhängigen mittleren Signalwert. Die Amplitude der Signalschwankung mit der Frequenz f3 am Integratorausgang ist daher ein Maß für die übereinstimmung der beiden Bitfolgen. Zur Messung der Übereinstimmung wird die Signalkomponente der Frequenz f3 am Ausgang des Integrators mit Hilfe eines auf die Frequenz f3 abgestimmten Bandpaßfilters BP ausgefiltert, und sodann mittels eines AM-Demodulators AMD (dafür kommt z.B. ein Spitzenwertgleichrichter in Frage) deren Amplitude bestimmt. Das analoge Ausgangssignal AS1 des AM-Demodulators gibt dann an, wie sehr die beiden Bitfolgen übereinstimmen. Auch dieses Signal AS1 kann mit mit Hilfe eines Komparators CM1 mit variabler Ansprechschwelle TH1 zur Kontrastverbesserung in ein Digitalsignal DS1 umwandeln. Beide Signale können, ebenso wie die Signale AS und DS, aufgezeichnet und dargestellt werden. Ist die Integrationszeit des Integrators INT größer als die Periodendauer 1/2πf3, so sind die Signale AS und DS unmittelbar ein Maß für die Übereinstimmung des Signals am Meßort und der Referenzbitfolge. Allerdings ist in diesem Fall das Signal-Rausch-Verhältnis wesentlich schlechter. Auch bei einem Verfahren und einer Vorrichtung nach Fig. 2 kann aus den zuvor bereits erwähnten Gründen der Einsatz eines Spektrometers SP vorteilhaft sein.

Nach einer weiteren Ausgestaltung der Erfindung wird im Gegensatz zur zuvor beschriebenen Meßvorrichtung nicht der Primärelektronenstrahl PE, sondern der Sekundärelektronenstrom SE mit der Referenzbitfolge RS moduliert. Als Modulator kann ein Gegenfeldspektrometer, wie es beispielsweise aus der US-Patentschrift 4 292 519 bekannt ist, dienen, wenn das Gegenfeld dieses Spektrometers durch die Referenzbitfolge gesteuert wird, Ansonsten enspricht diese Meßvorrichtung der in Fig. 2 dargestellten Anordnung. Der Vorteil dieses Verfahrens liegt darin, daß kein Strahlaustastsystem BBS erforderlich ist. Allerdings ist auch wegen der relativ hohen Kapazität eines Spektrometers die erreichbare Grenzfrequenz geringer. Zur Modulation des Sekundärelektronenstromes kann auch ein Detektor, dessen Absaugspannung von der Referenzbitfolge gesteuert wird, dienen.

Nach einer weiteren Ausgestaltung der Erfindung wird anstelle des Primärelektronenstrahles das Sekundärelektronensignal mit der Referenzbitfolge etwa mit Hilfe einer Gate-Schaltung moduliert.

Auch bei den zuletzt beschriebenen Verfahren und Meßvorrichtungen kann es, ebenso wie bei dem Verfahren nach Fig. 1, zur besseren Orientierung in der zweidimensionalen Abbildung einer Probe von Vorteil sei, das Sekundärelektronen-Topographiesignal oder ein anderes Topographiesignal zum jeweiligen Ausgangssignal hinzuzuaddieren.

Bei einer Vorrichtung und einem Verfahren nach der Erfindung muß das gesuchte Referenzsignal RS keineswegs nur auf theoretischem Weg aus der Simulation gewonnen werden. Es kann ebenso mit einem der bekannten Verfahren der Elektronenstrahlmeßtechnik an einem Meßpunkt im Innern der integrierten Schaltung IC gemessen und sodann in das Schieberegister SR2 bzw. SR eingelesen werden.

Selbstverständlich muß das Sekundärelektronensignal am Meßort nicht unbedingt durch Potentialkontrast entstehen. Jede andere Beeinflussung des Sekundärelektronenstromes durch das Signal am Meßort ist ebenso dazu geeignet. Ein Beispiel hierfür ist die Beeinflussung der Sekundärelektronen durch magnetische Felder (magnetischer Kontrast). Dies ist z.B. bei der Verwendung von Magnetblasenspeichern als Probe IC der Fall.

**Patentansprüche**

1. Verfahren zur Detektion und/oder Abbildung mit Hilfe eines Korpuskularmikroskops von Meßpunkten auf einer Probe (IC), die ein bestimmtes Signal (h(t)) führen, bei dem die Probe elektrisch augesteuert wird, bei dem mindestens ein Meßpunkt mit einem primären Korpuskularstrahl (PE) beaufschlagt wird, bei dem die vom primären Korpuskularstrahl (PE) ausgelösten Sekundärkorpuskeln (SE) in einem Detektor (DT) nachgewiesen werden und bei dem ein Sekundärkorpuskelsignal (DSE) erzeugt wird, das als Meßsignal weiterverarbeitet wird, dadurch gekennzeichnet, daß das Sekundärkorpuskelsignal (DSE) mit einem Referenzsignal (RS) verglichen wird und daß ein erstes Ausgangssignal (AS, DS, AS1, DS1) erzeugt wird, das den Grad der Übereinstimmung beider Signale angibt.

2. Verfahren nach Anspruch 1, dadurch gekennzeichnet, daß der Vergleich mit Hilfe eines Korrelationsverfahrens durchgeführt wird.

3. Verfahren nach Anspruch 1 oder 2, dadurch gekennzeichnet, daß der Vergleich mit dem Referenzsignal (RS) phasenunempfindlich vorgenommen wird.

4. Verfahren nach Anspruch 1 oder 2, dadurch gekennzeichnet, daß der Vergleich mit dem Referenzsignal (RS) phasenempfindlich vorgenommen wird.

5. Verfahren nach einem der Ansprüche 1 bis 4, dadurch gekennzeichnet, daß das Sekundärkorpuskelsignal nach einer Signalverarbeitung zur Verbesserung des Signal-Rausch-Verhältnisses und/oder zur Signalformung einem Korrelator (KOR) zugeführt wird.

6. Verfahren nach einem der Ansprüche 2 bis 4, dadurch gekennzeichnet, daß der Strom der Primärkorpuskeln (PE) mit dem Referenzsignal (RS) moduliert wird.

7. Verfahren nach einem der Ansprüche 2 bis 4, dadurch gekennzeichnet, daß der Strom der Sekundärkorpuskeln (SE) mit dem Referenzsignal (RS) moduliert wird.

8. Verfahren nach einem der Ansprüche 2 bis 4, dadurch gekennzeichnet, daß das gemessene Sekundärkorpuskularsignal mit dem Referenzsignal (RS) moduliert wird.

9. Verfahren nach einem der Ansprüche 6 bis 8, dadurch gekennzeichnet, daß das erste Ausgangssignal (AS) durch Integration des Sekundärkorpuskelsignals erzeugt wird.

10. Verfahren nach Anspruch 9, dadurch gekennzeichnet, daß die Integration durch die Nachleuchtdauer einer Bildröhre bewirkt wird.

11. Verfahren nach einem der Ansprüche 6 bis 10, dadurch gekennzeichnet, daß das Referenzsignal (RS) periodisch mit einer ersten Frequenz (f3) gegenüber dem bestimmten Signal (h(t)) verzögert wird.

12. Verfahren nach Anspruch 11, dadurch gekennzeichnet, daß aus dem integrierten Sekundärkorpuskelsignal (AS) ein Signalanteil mit der ersten Frequenz (f3) ausgefiltert wird und daß ein zweites Ausgangssignal (AS1) durch Demodulation dieses Signalanteils erzeugt wird.

13. Verfahren nach einem der Ansprüche 1 bis 12, dadurch gekennzeichnet, daß ein Ausgangssignal (AS, AS1) mit einem Schwellenwert (VZ, TH, TH1) verglichen wird und daß das Ergebnis des Vergleichs ein drittes Ausgangssignal (DS, DS1) bestimmt.

14. Verfahren nach einem der Ansprüche 1 bis 13, dadurch gekennzeichnet, daß der primäre Korpuskularstrahl (PE) über die Oberfläche der Probe (IC) abgelenkt wird.

15. Verfahren nach einem der Ansprüche 1 bis 14, dadurch gekennzeichnet, daß ein Topographiesignal erzeugt wird.

16. Verfahren nach einem der Ansprüche 1 bis 15, dadurch gekennzeichnet, daß einem Ausgangssignal (AS, DS, AS1, DS1) ein Topographiesignal überlagert wird.

17. Verfahren nach einem der Ansprüche 1 bis 16, dadurch gekennzeichnet, daß ein Ausgangssignal (AS, DS, AS1, DS1) und gegebenenfalls ein Topographiesignal aufgezeichnet werden.

18. Verfahren nach einem der Ansprüche 1 bis 17, dadurch gekennzeichnet, daß das Referenzsignal (RS) durch eine Messung an einem der Meßpunkte gewonnen wird.

19. Verfahren nach einem der Ansprüche 1 bis 18, dadurch gekennzeichnet, daß aus dem Sekundärkorpuskelsignal ein neues Signal gebildet und mit dem Referenzsignal (RS) verglichen wird.

20. Verfahren nach Anspruch 19, dadurch gekennzeichnet, daß der Vergleich mit Hilfe eines Korrelationsverfahrens durchgeführt wird.

21. Vorrichtung zur Detektion und/oder Abbildung von Meßpunkten auf einer Probe (IC), die ein bestimmtes Signal (h(t)) führen, mit einem Korpuskularmikroskop, das eine Quelle (EG) zur Erzeugung eines primären Korpuskularstrahls (PE) und einen Detektor (DT) zum Nachweis der an einem Meßpunkt ausgelösten Sekundärkorpuskeln (SE) aufweist, mit einer Probenansteuerung (CON) zur Zuführung eines Signals an den Meßpunkt und mit einer Signalkette zur Erzeugung eines Sekundärkorpuskelsignals (DSE) gekennzeichnet durch einen eingangsseitig mit einem Ausgang der Signalkette verbundenen Korrelator (KOR), der das Sekundärkorpuskelsignal (DSE) mit einem Referenzsignal (RS) vergleicht und ein Ausgangssignal erzeugt, das den Grad der Übereinstimmung beider Signale angibt.

22. Vorrichtung nach Anspruch 21, dadurch gekennzeichnet, daß die Signalkette eine Signalverarbeitungsschaltung (SV) zur Verbesserung des Signal- Rausch- Verhältnisses und/oder zur Signalformung aufweist.

23. Vorrichtung zur Detektion und/oder Abbildung von Meßpunkten auf einer Probe (IC), die ein bestimmtes Signal (h(t)) führen, mit einem Korpuskularmikroskop, das eine Quelle (EG) zur Erzeugung eines primären Korpuskularstrahls (PE) und einen Detektor (DT) zum Nachweis der an einem Meßpunkt ausgelösten Sekundärkorpuskeln (SE) aufweist, mit einer Probenansteuerung (CON) zur Zuführung eines Signals an den Meßpunkt und mit einer Signalkette zur Erzeugung eines Sekundärkorpuskelsignals, gekennzeichnet durch ein Austastsystem (BBS) zur Modulation des primären Korpuskularstrahls (PE), eine Schaltung (SR, AMP) zur Ansteuerung des Austastsystems (BBS) mit einem Referenzsignal (RS) und einen Integrator (INT), an dessen Eingang das Sekundärkorpuskelsignal anliegt.

24. Vorrichtung nach Anspruch 23, gekennzeichnet durch einen Generator (GDL), ein vom Generator (GDL) angesteuertes Verzögerungsglied (DL), das das Referenzsignal (RS) gegenüber dem bestimmten Signal (h(t)) periodisch mit einer ersten Frequenz (f3) verzögert, ein auf die erste Frequenz (f3) abgestimmtes Bandpaßfilter (BP), an dessen Eingang das Ausgangssignal des Integrators (INT) anliegt und einen mit dem Ausgang des Bandpaßfilters (BP) verbundenen Demodulator (AMD).

25. Vorrichtung nach Anspruch 23 oder 24, gekennzeichnet durch die Abwandlung, daß das Austastsystem (BBS) durch eine Vorrichtung zur Modulation des Stroms der Sekundärkorpuskeln (SE) und die Ansteuerung des Austastsystems (BBS) durch eine Schaltung zur Ansteuerung der Vorrichtung zur Modulation des Stroms der Sekundärkorpuskeln (SE) ersetzt ist.

26. Vorrichtung nach Anspruch 23 oder 24, gekennzeichnet durch die Abwandlung, daß das Austastsystem (BBS) durch eine Vorrichtung zur Modulation des Sekundärkorpuskelsignals und die Ansteuerung des Austastsystems (BBS) durch eine Schaltung zur Ansteuerung der Vorrichtung zur Modulation des Sekundärkorpuskelsignals ersetzt ist.

27. Vorrichtung nach einem der Ansprüche 21 bis 27, gekennzeichnet durch einen Komparator (KOM, CM, CM1) zum Vergleich eines Ausgangssignals (AS, AS1) mit einem Schwellenwert (VZ, TH, TH1).

28. Vorrichtung nach einem der Ansprüche 21 bis 27, gekennzeichnet durch ein Spektrometer (SP) zur Unterdrückung von Störungen und/oder zur quantitativen Bestimmung des Sekundärkorpuskelsignals.

29. Vorrichtung nach einem der Ansprüche 21 bis 28, gekennzeichnet durch eine Einrichtung zur Aufzeichnung eines Ausgangssignals und gegebenenfalls eines Topographiesignals.

**Revendications**

1. Procédé pour détecter et/ou représenter, à l'aide d'un microscope à faisceau corpusculaire, des points de mesure situés sur un échantillon (IC) et présentant un signal déterminé (h(t)), et dans lequel l'échantillon est commandé électriquement, au moins un point de mesure est chargé par un faisceau corpusculaire primaire (PE), les corpuscules secondaires (SE) déclenchés par le faisceau corpusculaire primaire (PE) sont détectés dans un détecteur (DT) et un signal des corpuscules secondaires (DSE), qui continue à être traité en tant que signal de mesure, est produit, caractérisé par le fait que le signal des corpuscules secondaires (DSE) est comparé à un signal de référence (RS) et qu'un premier signal de sortie (AS, DS, AS1, DS1), qui indique le degré de coïncidence entre les deux signaux, est produit.

2. Procédé suivant la revendication 1, caractérisé par le fait que la comparaison est exécutée à l'aide d'un procédé de corrélation.

3. Procédé suivant la revendication 1 ou 2, caractérisé par le fait que la comparaison au signal de référence (RS) est exécutée d'une manière insensible vis-à-vis de la phase.

4. Procédé suivant la revendication 1 ou 2, caractérisé par le fait que la comparaison au signal de référence (RS) est réalisée d'une manière sensible à la phase.

5. Procédé suivant l'une des revendications 1 à 4, caractérisé par le fait que le signal des corpuscules secondaires est envoyé à un corrélateur (KOR), après son traitement visant à améliorer le rapport signal/bruit et/ou mettre en forme le signal.

6. Procédé suivant l'une des revendications 2 à 4, caractérisé par le fait que le courant des corpuscules primaires (PE) est modulé par le signal de référence (RS).

7. Procédé suivant l'une des revendications 2 à 4, caractérisé par le fait que le courant des corpuscules secondaires (SE) est modulé par le signal de référence (RS).

8. Procédé suivant l'une des revendications 2 à 4, caractérisé par le fait que le signal mesuré des corpuscules secondaires est modulé par le signal de référence (RS).

9. Procédé suivant l'une des revendications 6 à 8, caractérisé par le fait que le premier signal de sortie (RS) est produit par intégration du signal des corpuscules secondaires.

10. Procédé suivant la revendication 9, caractérisé par le fait que l'intégration est obtenue sur la base de la durée de persistance d'un tube de prise de vues.

11. Procédé suivant l'une des revendications 6 à 10, caractérisé par le fait que le signal de référence (RS) est retardé périodiquement avec une première fréquence (f3) par rapport au signal déterminé (h(t)).

12. Procédé suivant la revendication 11, caractérisé par le fait qu'une composante de signal possédant la première fréquence (f3) est extraite par filtrage du signal intégré des corpuscules secondaires (AS) et qu'un second signal de sortie (AS1) est produit par démodulation de cette composante de signal.

13. Procédé suivant l'une des revendications 1 à 12, caractérisé par le fait qu'un signal de sortie (AS, AS1) est comparé à une valeur de seuil (VZ, TH, TH1) et que le résultat de la comparaison détermine un troisième signal de sortie (DS, DS1).

14. Procédé suivant l'une des revendications 1 à 13, caractérisé par le fait que le faisceau corpusculaire primaire (PE) est déplacé au-dessus de la surface de l'échantillon (IC).

15. Procédé suivant l'une des revendications 1 à 14, caractérisé par le fait qu'un signal de topographie est produit.

16. Procédé suivant l'une des revendications 1 à 15, caractérisé par le fait qu'un signal de topographie est superposé au signal de sortie (AS, DS, AS1, DS1).

17. Procédé suivant l'une des revendications 1 à 7, caractérisé par le fait qu'un signal de sortie (AS, DS, AS1, DS1) et éventuellement un signal de topographie sont enregistrés.

18. Procédé suivant l'une des revendications 1 à 17, caractérisé par le fait que le signal de référence (AS1) est obtenu au moyen d'une mesure effectuée en l'un des points de mesure.

19. Procédé suivant l'une des revendications 1 à 18, caractérisé par le fait qu'un nouveau signal est formé à partir du signal des corpuscules secondaires et est comparé au signal de référence (RS).

20. Procédé suivant la revendication 19, caractérisé par le fait que la comparaison est exécutée à l'aide d'un procédé de corrélation.

21. Dispositif pour détecter et/ou représenter des points de mesure situés sur un échantillon (IC) et présentant un signal déterminé (h(t)), à l'aide d'un microscope à faisceau corpusculaire, qui comporte une source (EG) servant à produire un faisceau corpusculaire primaire (PE) et un détecteur (DT) servant à détecter les corpuscules secondaires (SE) produits en un point de mesure, un dispositif (CON) de commande de l'échantillon, qui sert à envoyer un signal au point de mesure et une chaîne de transmission du signal servant à produire un signal (DSE) des corpuscules secondaires, caractérisé par un corrélateur (KOR), qui est relié côté entrée à une sortie de la chaîne de transmission du signal, compare le signal (DSE) des corpuscules secondaires à un signal de référence (RS) et produit un signal de sortie qui indique le degré de coïncidence entre les deux signaux.

22. Dispositif suivant la revendication 21, caractérisé par le fait que la chaîne de transmission du signal comporte un circuit (S2) de traitement du signal, qui sert à améliorer le rapport signal/bruit et/ou à mettre en forme le signal.

23. Dispositif pour détecter et/ou représenter des points de mesure situés sur un échantillon (IC) et présentant un signal déterminé (h(t)), à l'aide d'un microscope à faisceau corpusculaire, qui comporte une source (EG) servant à produire un faisceau corpusculaire primaire (PE) et un détecteur (DT) servant à détecter les corpuscules secondaires (SE) produits en un point de mesure, un dispositif (CON) de commande de l'échantillon, qui sert à envoyer un signal au point de mesure et une chaîne de transmission du signal servant à produire un signal (DSE) des corpuscules secondaires, caractérisé par un système de commande de suppression (BBS) servant à moduler le faisceau corpusculaire primaire (PE), un circuit (SR, MP) servant à commander le système de suppression (BBS) avec un signal de référence (RS) et un intégrateur (INT), à l'entrée duquel est appliqué le signal des corpuscules secondaires.

24. Dispositif suivant la revendication 23, caractérisé par un générateur (GDL), un circuit à retard (DL), qui est commandé par le générateur (GDL) et retarde le signal de référence (RS) périodiquement avec une première fréquence (f3) par rapport au signal déterminé (h(t)), un filtre passebande (BP), qui est réglé sur la première fréquence (f3) et à l'entrée duquel est appliqué signal de sortie de l'intégrateur (INT), et un démodulateur (AMD) relié à la sortie du filtre passe-bande (BP).

25. Dispositif suivant la revendication 23 ou 24, caractérisé par la modification consistant en ce que le système de suppression (BBS) est remplacé par un dispositif servant à moduler le courant (SE) des corpuscules secondaires et que le circuit de commande du système de suppression (BBS) est remplacé par un circuit servant à commander le dispositif servant à moduler le courant (SE) des corpuscules secondaires.

26. Dispositif suivant la revendication 23 ou 24, caractérisé par la modification consistant en ce que le système de suppression (BBS) est remplacé par un dispositif servant à moduler le signal des corpuscules secondaires et que le circuit de commande du système de suppression (BBS) est remplacé par un circuit servant à commander le dispositif servant à moduler le signal des corpuscules secondaires.

27. Dispositif suivant l'une des revendications 21 à 27, caractérisé par un comparateur (KOM, CM, CM1) servant à comparer un signal de sortie (AS, AS1) à une valeur de seuil (VZ, TH, TH1).

28. Dispositif suivant l'une des revendications 21 à 27, caractérisé par un spectromètre (SP) servant à supprimer des parasites et/ou à réaliser la détermination quantitative du signal des corpuscules secondaires.

29. Dispositif suivant l'une des revendications 21 à 28, caractérisé par un dispositif servant à enregistrer un signal de sortie et éventuellement un signal de topographie.

## Claims

1. Method for detecting and/or imaging with the aid of a particle microscope, of measuring points on a test specimen (IC) which measuring points conduct a defined signal (h(t)), in which the test specimen is electrically actuated, in which at least one measuring point is impinged upon by a primary particle beam (PE), in which the secondary particles (SE) triggered by the primary particle beam (PE) can be detected in a detector (DT) and in which a secondary particle signal (DSE) is generated which is further processed as a measuring signal, characterized in that the secondary particle signal (DSE) is compared with a reference signal (RS) and in that a first output signal (AS, DS, AS1, DS1) is generated which indicates the degree of coincidence between the two signals.

2. Method according to Claim 1, characterized in that the comparison is made by correlation method.

3. Method according to Claim 1 or 2, characterized in that the comparison with the reference signal (RS) is made independently of phase.

4. Method according to Claim 1 or 2, characterized in that the comparison with the reference signal (RS) is made depending on phase.

5. Method according to Claims 1 to 4, characterized in that the secondary particle signal, after signal processing for improving the signal-to-noise ratio and/or for signal shaping, is supplied to a correlator (KOR).

6. Method according to one of Claims 2 to 4 characterized in that the stream of primary particles (PE) is modulated with the reference signal (RS).

7. Method according to one of Claims 2 to 4, characterized in that the stream of secondary particles (SE) is modulated with the reference signal (RS).

8. Method according to one of Claims 2 to 4 characterized in that the measured secondary particle signal is modulated with the reference signal (RS).

9. Method according to one of Claims 6 to 8, characterized in that the first output signal (AS) is generated by integration of the secondary particle signal.

10. Method according to Claim 9, characterized in that the integration is affected by the luminescence of a picture tube.

11. Method according to one of Claims 6 to 10, characterized in that the reference signal (RS) is periodically delayed with a first frequency (f3) in relation to the defined signal (h(t)).

12. Method according to Claim 11, characterized in that, from the integrated secondary particle signal (AS) a signal portion with the first frequency (f3) is filtered out and in that a second output signal (AS1) is generated by demodulation of this signal portion.

13. Method according to one of Claims 1 to 12, characterized in that an output signal (AS, AS1) is compared with a threshold value (VZ, TH, TH1) and in that the result of the comparison determines a third output signal (DS, DS1).

14. Method according to on of Claims 1 to 13 characterized in that the primary particle beam (PE) is deflected over the surface of the test specimen (IC).

15. Method according to one of Claims 1 to 14, characterized in that a topography signal is generated.

16. Method according to one of Claims 1 to 15 characterized in that a topography signal is superimposed on an output signal (AS, DS, AS1, DS1).

17. Method according to one of Claims 1 to 16, characterized in that an output signal (AS, DS, AS1, DS1) and if appropriate a topography signal are recorded.

18. Method according to one of Claims 1 to 17, characterized in that the reference signal (RS) is gained by a measurement at one of the measuring points.

19. Method according to one of Claims 1 to 18, characterized in that a new signal is formed from the secondary particle signal and compared with the reference signal (RS).

20. Method according to Claim 19, characterized in that the comparison is performed with the aid of a correlation method.

21. Apparatus for detecting and/or imaging of measuring points on a test specimen (IC) which conduct a defined signal (h(t)), having a particle microscope, which has a source (EG) for generating a primary particle beam (PE) and a detector (DT) for detecting the secondary particles (SE) triggered at a measuring point, having a test specimen drive (CON) for supplying a signal to the measuring point and having a signal chain for generating a secondary particle signal (DSE), characterized by a correlator (KOR) connected on its input side to an output of the signal chain, which correlator compares the secondary particle signal (DSE) with a reference signal (RS) and generates an output signal which specifies the degree of coincidence of the two signals.

22. Apparatus according to Claim 21, characterized in that the signal chain has a signal processing circuit (SV) for improving the signal-to-noise ratio and/or for signal shaping.

23. Apparatus for detecting and/or imaging of measuring points on a test specimen (IC) which measuring points conduct a defined signal (h(t)), having a particle microscope which has a source (EG) for generating a primary particle beam (PE) and a detector (DT) for detecting the secondary particles (SE) triggered at a measuring point, having a test specimen drive (CON) for supplying a signal to the measuring point and having a signal chain for generating a secondary particle signal, characterized by a blanking system (BBS) for modulating the primary particle beam (PE), a circuit (SR, AMP) for driving the blanking system (BBS) with a reference signal (RS) and an integrator (INT), at the input of which the secondary particle signal is applied.

24. Apparatus according to Claim 23, characterized by a generator (GDL), a delay element (DL) driven by the generator (GDL) which delay element delays the reference signal (RS) periodically with a first frequency (f3) in relation to the defined signal (h(t)), a bandpass filter (BP), tuned to the first frequency (f3), at the input of which bandpass filter the output signal of the integrator (INT) is applied and a demodulator (AMD) connected to the output of the bandpass filter (BP).

25. Apparatus according to Claim 23 or 24 characterized by the modification that the blanking system (BBS) is replaced by an apparatus for modulating the stream of secondary particles (SE) and the drive of the blanking system (BBS) is replaced by a circuit for driving the apparatus for modulating the stream of secondary particles (SE).

26. Apparatus according to Claim 23 or 24, characterized by the modification that the blanking system (BBS) is replaced by an apparatus for modulating the secondary particle signal and the drive of the blanking system (BBS) is replaced by a circuit for driving the apparatus for modulating the secondary particle signal.

27. Apparatus according to one of Claims 21 to 27, characterized by a comparator (KOM, CM, CM1) for comparing an output signal (AS, AS1) with a threshold (VZ, TH, TH1).

28. Apparatus according to one of Claims 21 to 27, characterized by a spectrometer (SP) for suppressing interference and/or for quantitively defining the secondary particle signal.

29. Apparatus according to one of Claims 21 to 28, characterized by a device for recording an output signal and if appropriate a topography signal.

FIG 1

FIG 2